(19) Europäisches Patentamt

European Patent Office

Office européen des brevets

(11) EP 0 889 481 B1

(12) FASCICULE DE BREVET EUROPEEN

(45) Date de publication et mention
de la délivrance du brevet:
**10.09.2003 Bulletin 2003/37**

(51) Int Cl.⁷: $G11C$ 19/00

(21) Numéro de dépôt: **98401675.8**

(22) Date de dépôt: **03.07.1998**

(54) **Perfectionnement aux mémoires à accès séquentiels.**

Verbesserungen von Speicherschaltungen mit sequentiellem Zugriff

Improvements of sequential access memories

(84) Etats contractants désignés:
**DE FR GB IT**

(30) Priorité: **04.07.1997 FR 9708517**

(43) Date de publication de la demande:
**07.01.1999 Bulletin 1999/01**

(73) Titulaire: **STMicroelectronics S.A.**
**92120 Montrouge (FR)**

(72) Inventeurs:
• **Pomet, Alain**
**92593 Levallois-Perret Cedex (FR)**

• **Plessier, Bernard**
**92593 Levallois-Perret Cedex (FR)**

(74) Mandataire: **Ballot, Paul et al**
**Cabinet Ballot**
**122, rue Edouard Vaillant**
**92593 Levallois-Perret Cedex (FR)**

(56) Documents cités:
**EP-A- 0 645 775**     **GB-A- 2 183 374**
**US-A- 5 295 174**

## Description

La présente invention concerne un perfectionnement aux mémoires à accès séquentiels. Elle s'applique notamment à la sauvegarde de données sur des cartes à puce. Une mémoire est dite à accès séquentiels lorsque les bits d'information se présentent sous forme série à l'entrée d'un registre mémoire à la sortie duquel ils sont délivrés, également sous forme série, avec un certain retard, et dans leur ordre d'entrée (d'où leur dénomination anglo-saxonne de "First In First Out" ou Fi-Fo").

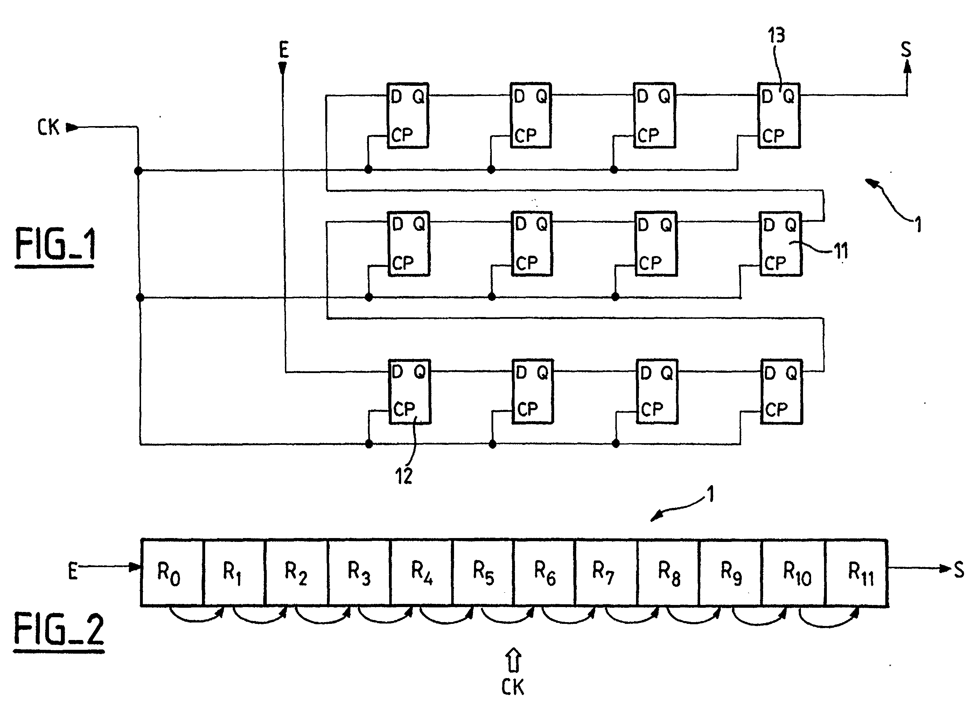

A la figure 1, on a représenté un mode de réalisation connu d'une telle mémoire. Cette mémoire comporte en série N éléments de registre qui sont par exemple des bascules de type D (dites également "bascules de recopie") comme la bascule 11, qui sont des bascules bistables et synchrones. Par l'expression bistable on entend que la sortie Q de la bascule peut prendre deux états logiques stables différents (haut et bas). Par l'expression synchrone, on signifie que la sortie de la bascule ne peut changer d'état que lorsqu'un front de signal, par exemple un front montant, est appliqué sur une entrée d'horloge CP de la bascule (on dira alors que la bascule est activée), l'état logique de l'entrée D étant alors recopié en sortie Q et maintenu jusqu'à l'apparition d'un nouveau front sur l'entrée CP, et ce, quelle que soit l'évolution du signal sur l'entrée D entre ces deux fronts.

La connexion en série de bascules D est telle que la sortie Q d'une bascule déterminée est transmise à l'entrée D de la bascule suivante. Par exemple, le registre 1 de mémoire de structure connue qui est représenté à la figure 1 comporte douze bascules D ainsi connectées en série, chacune recevant simultanément un signal d'horloge CK sur son entrée d'horloge CP. Les bits de données se présentent successivement sur l'entrée E du registre constituée par l'entrée D de la première bascule 12 sont transmis successivement d'une bascule à l'autre au rythme des fronts montants du signal d'horloge, pour être finalement délivrés en sortie de l'ultime bascule 13 après la douzième impulsion du signal d'horloge. La sortie de la bascule 13 constitue la sortie du registre de mémoire.

Eventuellement, de façon également connue, on reboucle la sortie du registre sur son entrée via un moyen d'aiguillage de données de manière à faire circuler les données dans le serpentin constitué par le registre ainsi bouclé. On évite ainsi la perte d'information (le registre comporte alors nécessairement un nombre de bascules au moins égal au nombre de bits de données à mémoriser, et préférentiellement égal à ce nombre).

A la figure 2, on a représenté une vue schématique du registre 1 de la figure 1, faisant apparaître les douze éléments de registre R0 à R11 constitués par les bascules D de la figure 1. Les flèches entre les éléments de registre matérialisent la transmission des bits de données d'un élément à l'autre, qui s'effectue au rythme des fronts montants du signal d'horloge CK appliqué simultanément à tous les éléments.

L'inconvénient majeur de cette architecture connue de mémoire à accès séquentiels réside dans sa très forte consommation dynamique en courant. En effet, un cycle complet d'écriture d'un mot de N bits dans un registre comprenant N éléments de registre nécessite N temps d'horloge pendant lesquels les N registres sont simultanément activés. Si l'on note e l'énergie élémentaire consommée par un élément de registre du fait de son activation par un front du signal d'horloge (on parlera de sa consommation dynamique par opposition à sa consommation statique lors des phases de maintien s'écoulant entre deux activations successives), c'est alors une énergie dynamique égale à $ED = N \times N \times e$ qui est consommée par le registre. Ce bilan d'énergie est néfaste à un double titre. D'une part l'énergie consommée par le registre occasionne un échauffement du circuit électronique l'incorporant et doit être dissipée vers l'extérieur, ce qui est un facteur limitant l'évolution actuelle vers de très fortes densités d'intégration. D'autre part, cette consommation en courant décharge l'accumulateur alimentant le circuit pour son fonctionnement, ce qui est particulièrement dommageable lorsque ledit circuit est utilisé dans un appareil portatif auto-alimenté ou télé-alimenté par couplage inductif.

L'objet de la présente invention est de pallier les inconvénients de l'état de la technique précités. En effet, l'invention propose une mémoire à accès séquentiels fonctionnant au rythme d'un signal d'horloge et comprenant N éléments de registre bistables et synchrones mémorisant chacun un bit d'information. Les N éléments sont répartis en P groupes comprenant chacun L éléments. Une unité de gestion fait fonctionner la mémoire de telle manière que dans une première phase de fonctionnement dont la durée correspond à P - 1 périodes consécutives du signal d'horloge, seuls les derniers éléments de chaque groupe sont activés simultanément et sont par ailleurs connectés en série, l'entrée du premier de ces éléments constituant alors l'entrée de la mémoire et la sortie du dernier élément constituant alors la sortie de la mémoire, alors que, dans une seconde phase de fonctionnement dont la durée correspond à une unique période du signal d'horloge, tous les éléments sont activés simultanément, les groupes d'éléments étant en outre connectés en série, l'entrée du premier élément du premier groupe constituant alors l'entrée de la mémoire, et la sortie du dernier élément du dernier groupe constituant alors la sortie de la mémoire.

On peut montrer que, grâce à l'invention, la consommation dynamique, maximum et moyenne, de la mémoire est significativement réduite par rapport à celle des mémoires selon l'art antérieur. En effet, on s'aperçoit que, selon l'invention, certains éléments de mémoire ne sont activés que pendant la deuxième phase de fonctionnement qui est très brève et ne contribuent donc pas sensiblement à la consommation dynamique de la mémoire.

D'autres caractéristiques et avantages de l'invention apparaîtront encore à la lecture de la description qui va suivre. Celle-ci est purement illustrative et doit être lue en regard des dessins annexés sur lesquels on a représenté:

- à la figure 1 et à la figure 2 déjà analysées, respectivement une structure de mémoire connue ainsi qu'une vue schématique du registre de cette mémoire;
- à la figure 3 une représentation de la structure de la mémoire selon l'invention;
- à la figure 4 une vue schématique du registre de la mémoire de la figure 3;
- à la figure 5 une vue schématique de ce registre pendant la première phase de fonctionnement;
- à la figure 6 une vue schématique de ce registre pendant la seconde phase de fonctionnement;
- aux figures 7a à 7d des chronogrammes de signaux de fonctionnement de la mémoire selon l'invention;
- à la figure 8 un tableau montrant l'état du registre de la figure 4 au cours du temps.

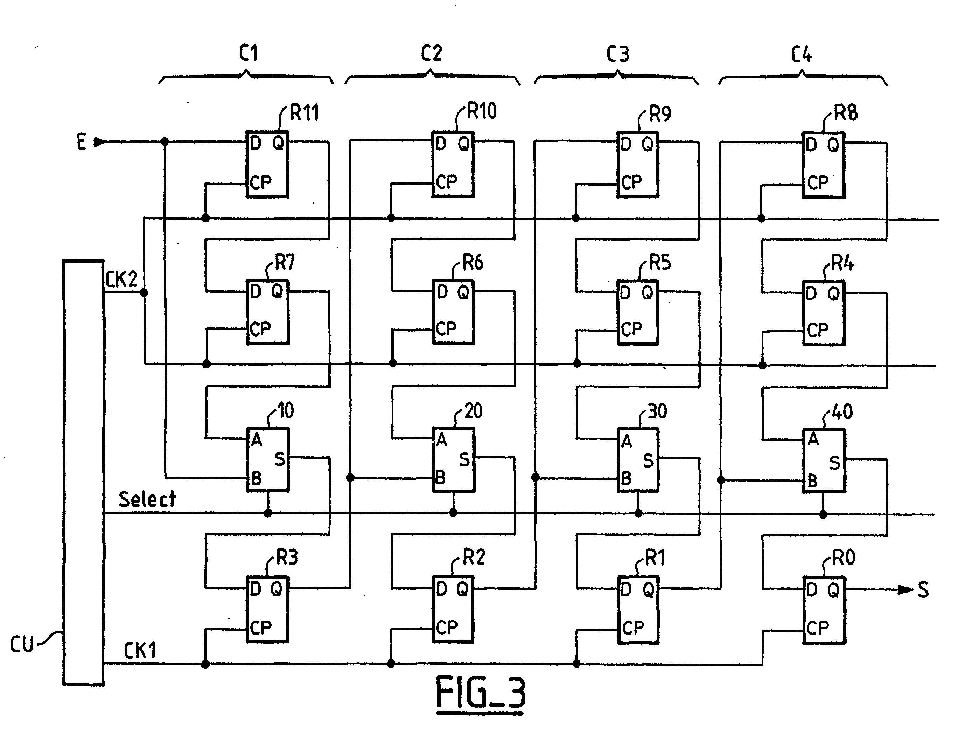

A la figure 3 on a représenté un exemple de réalisation de l'invention dans le cas d'un registre mémoire comportant douze éléments de registre tels que par exemple des bascules D, réparties selon l'invention en quatre groupes C1 à C4 comprenant chacun trois bascules. Il est bien évident que le principe de l'invention se généralise à un registre de mémoire comprenant N éléments répartis en P groupes de L éléments chacun, avec N = L x P.

Le premier groupe de bascules C1 comporte donc trois bascules R11, R7 et R3 connectées en série. Plus précisément la sortie Q de la bascule R11 est connectée à l'entrée D de la bascule R7 dont la sortie Q est elle-même transmise à une première entrée A d'un multiplexeur 10 à deux entrées (ou voies) dont la sortie est connectée à l'entrée D de la troisième bascule R3, et dont une deuxième entrée B est connectée à l'entrée E du registre. Le deuxième groupe de bascules C2 comprend trois bascules R10, R6 et R2 connectées en série. La sortie Q de la troisième bascule R3 du premier groupe est connectée à l'entrée D de la première bascule R10 du second groupe C2 dont la sortie Q est connectée à l'entrée D de la deuxième bascule R6 dudit groupe C2. La sortie Q de ladite bascule R6 est elle-même connectée sur une première entrée A d'un multiplexeur 20 à deux entrées (ou voies) dont la sortie S est connectée à l'entrée D de la troisième bascule R2 du groupe C2. Une deuxième entrée B du multiplexeur 20 est également connectée à la sortie Q de la troisième bascule R3 du premier groupe C1.

Le troisième groupe de bascules C3 comporte également trois bascules R9, R5 et R1. La sortie Q de la troisième bascule R2 du deuxième groupe C2 est connectée à l'entrée D de la première bascule R9 du troisième groupe C3 dont la sortie Q est connectée à l'entrée D de la deuxième bascule R5 dudit groupe. La sortie Q de la bascule R5 est connectée à une première entrée A d'un multiplexeur 30 à deux entrées (ou voies) dont la sortie S est connectée à l'entrée D de la troisième bascule R1 du groupe C3. La sortie Q de la troisième bascule R2 du deuxième groupe C2 est également connectée à une deuxième entrée B du multiplexeur 30.

Le quatrième groupe C4 comprend enfin les trois bascules R8, R4 et R0 connectées en série. La sortie Q de la troisième bascule R2 du groupe C3 est connectée à l'entrée D de la première bascule R8 du quatrième groupe C4 dont la sortie Q est connectée à l'entrée D de la deuxième bascule R4 dudit groupe. La sortie Q de la bascule R4 est connectée à une première entrée A d'un multiplexeur 40 à deux entrées (ou voies) dont la sortie S est connectée à l'entrée D de la troisième bascule R0 du groupe C4. La sortie Q de la troisième bascule R1 du troisième groupe C3 est également connectée à une deuxième entrée B du multiplexeur 40.

La sortie Q de la troisième bascule R0 du quatrième groupe C4 est connectée à la sortie S du registre de la mémoire.

Une troisième entrée de chacun des multiplexeurs 10, 20, 30 et 40 reçoit simultanément un même signal de sélection SELECT. Les entrées d'horloge CP des dernières bascules R13, R2, R1 et R0 de chacun des quatre groupes C1, C2, C3 et C4 reçoivent simultanément un premier signal de déclenchement CK1. Les entrées d'horloge CP des premières bascules R11, R10, R9 et R8 et des deuxième bascules R7, R6, R5 et R4 de chaque groupe C1, C2, C3 et C4 reçoivent simultanément un second signal de déclenchement CK2.

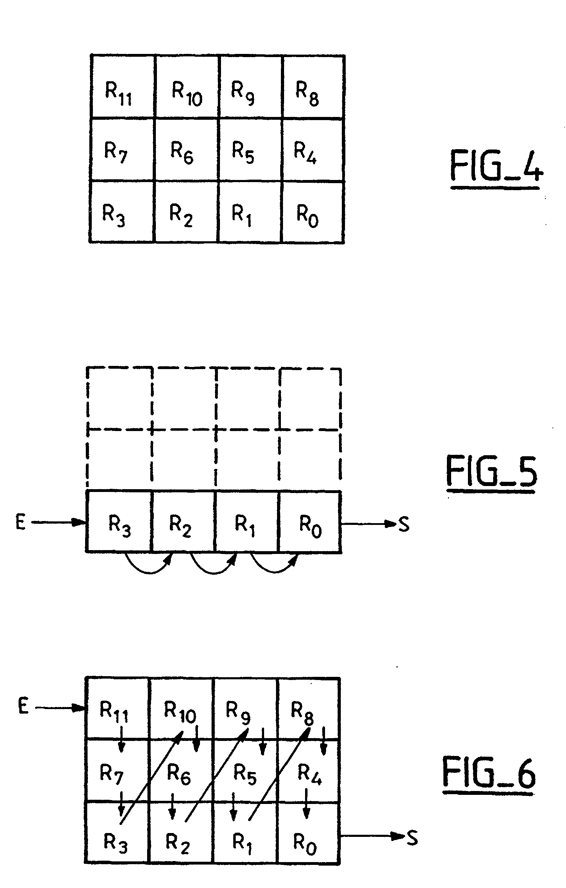

Schématiquement on peut représenter la mémoire selon l'invention sous la forme d'une matrice à quatre colonnes et trois lignes, ainsi qu'il est visible à la figure 4. Chaque élément de registre R0 à R11 constituant le registre de la mémoire, est réalisé par les bascules de la figure 3 portant les mêmes références. On peut ainsi voir que, schématiquement, un groupe de bascules déterminé C1, C2, C3 ou C4 correspond à une colonne de la matrice de la figure 4.

Le fonctionnement de l'invention va maintenant être décrit en considérant les figures 5 à 8.

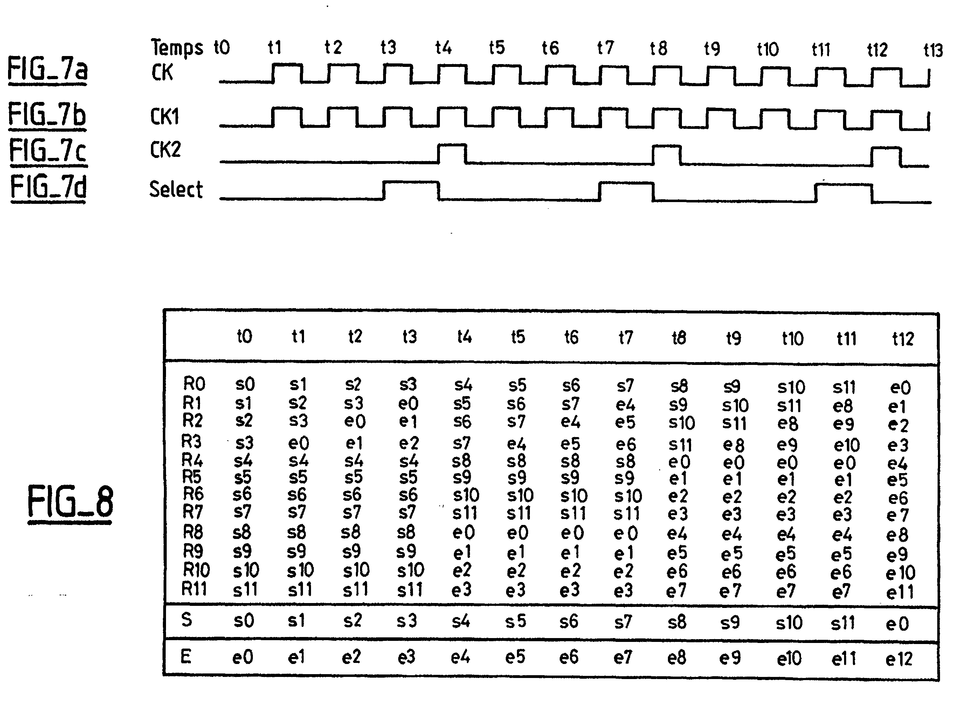

A la figure 7a, on a représenté un signal d'horloge CK du circuit électronique incorporant la mémoire selon l'invention. Ce signal est périodique de période 1/f. Il est à l'état haut pendant la première demi période et à l'état bas pendant le reste du temps, de sorte qu'il présente un front montant en début de période. Les fronts montants de ce signal CK se produisent à des instants référencés t0 à t13.

A la figure 7b on a représenté le premier signal de déclenchement CK1 qui, ainsi qu'il est visible, se confond avec le signal d'horloge CK.

A la figure 7c on a représenté le second signal de déclenchement CK2 qui est également un signal périodique. Toutefois, le premier signal CK1 présente des fronts montants aux instants t1 à t12 alors que le second signal CK2 ne présente de tels fronts qu'aux instants t4, t8 et t12.

A la figure 7D, on a enfin représenté un signal de sélection SELECT qui est à l'état haut entre les instants t3 et t4, de même qu'entre les instants t7 et t8 et entre les instants t11 et t12, et qui est à l'état bas le reste du temps.

Les signaux d'activation CK1, CK2 et le signal de sélection SELECT sont générés par une unité de gestion CU (figure 3) qui comprend essentiellement un compteur modulo 4 (modulo P dans le cas général) qui peut être complété par des portes logiques élémentaires. Ce compteur modulo P est avantageusement réalisé à l'aide de X bascules D montées en T (c'est-à-dire dont la sortie inverse Q- est reliée à l'entrée D de manière à ce que la sortie Q change d'état à chaque front se présentant sur son entrée d'horloge CP), où $X = \log_2 P$ est un nombre entier, la sortie Q d'une bascule déterminée autre que la dernière étant reliée à l'entrée D de la bascule suivante. C'est pourquoi on choisira préférentiellement une structure de mémoire dans laquelle P est une puissance entière de deux (c'est-à-dire $\log_2 P = X$, avec X entier).

Dans le tableau de la figure 8, on a indiqué l'état des éléments de registre R0 à R11 de la mémoire à chaque instant t0 à t12, ainsi que l'état de la sortie S et de l'entrée E de la mémoire à ces instants.

On note S0 à S11 les variables symbolisant l'état des registres R0 à R11 respectivement à l'instant initial t0 (variables sortantes). On note également E0 à E12 les variables représentant l'état logique des bits de données qui se présentent successivement à l'entrée E du registre de mémoire à chaque instant t1 à t12 respectivement (variables entrantes).

Ainsi qu'on l'aura compris, la lecture du tableau de la figure 8 permet de suivre l'évolution de l'état des éléments de registres R0 à R11 entre les instants t0 et t12.

Le fonctionnement de la mémoire se déroule selon deux phases distinctes qui sont définies par l'état du signal SELECT appliqué simultanément sur la troisième entrée de chacun des multiplexeurs 10, 20, 30 et 40 (figure 3). Dit autrement, les multiplexeurs sont commandés par le signal SELECT pour faire fonctionner la mémoire alternativement selon ladite première et ladite seconde phase de fonctionnement.

Le passage du signal SELECT de l'état bas à l'état haut est provoqué par le front montant du signal d'horloge CK qui se produit à l'instant t3. Le passage du signal SELECT de l'état haut à l'état bas est déterminé par le front montant du signal d'horloge CK se produisant à l'instant t4. La première phase de fonctionnement est définie par un signal SELECT à l'état bas, alors que la seconde phase de fonctionnement est déterminée par un signal SELECT à l'état haut.

Dans la première phase de fonctionnement, le signal transmis en sortie des multiplexeurs 10, 20, 30 et 40 est le signal porté sur la deuxième entrée B desdits multiplexeurs, alors que dans la seconde phase de fonctionnement il s'agira du signal porté sur leur première entrée A.

Ainsi, le fonctionnement de la mémoire au cours de la première phase de fonctionnement peut se résumer à la représentation schématique de la figure 5 sur laquelle on a représenté les éléments de registre R3, R2, R1 et R0 qui sont seuls activés, pendant ladite phase de fonctionnement, par les fronts montants du premier signal de déclenchement CK1. A la figure 5, les registres R4 à R11 qui ne sont pas activés au cours de la première phase de fonctionnement ont été représentés en traits discontinus. Le registre de la mémoire se comporte alors comme un registre à décalage comprenant les éléments de registre R3, R2, R1, R0 en série, l'entrée E de la mémoire étant l'entrée de l'élément de registre R3 et la sortie S étant la sortie de l'élément de registre R0. Les bits d'information se présentant sur l'entrée E se propagent d'un élément de registre à l'autre au rythme des fronts montants du premier signal de déclenchement CK1 de la figure 7b qui se produisent aux instants t1, t2 et t3. Ainsi la durée de la première phase de fonctionnement correspond à trois périodes consécutives du signal d'horloge CK (c'est à dire à P-1 périodes consécutives du signal CK dans le cas général).

Ainsi qu'il a été dit plus haut, le front montant du signal d'horloge CK se produisant à l'instant t3 provoque le passage du signal SELECT de l'état bas à l'état haut. Le signal en sortie de chacun des multiplexeurs 10, 20, 30 et 40 est alors le signal présent sur leur première entrée A. La sortie de la deuxième bascule R7, R6, R5 et R4 de chaque groupe C1, C2, C3 et C4 est alors connectée à l'entrée de la troisième bascule R3, R2, R1 et R0 desdits groupes via les multiplexeurs. Tout se passe alors comme si les douze bascules du registre de mémoire R11, R7, R3, R10, R6, R2, R9, R5, R1, R8, R4, R0 étaient connectées en série. Autrement dit, tout se passe comme si les quatre groupes de bascules C1, C2, C3 et C4 étaient connectés en série, la sortie Q de la dernière bascule d'un groupe déterminé (autre que le dernier C4) étant reliée à l'entrée D de la première bascule du groupe suivant. Le fonctionnement de la mémoire à l'instant t4 où un front montant se produit sur le signal d'horloge CK ainsi que sur le second signal de déclenchement CK2 peut alors se représenter schématiquement ainsi qu'il ressort de la figure 6. L'entrée E du registre de mémoire est alors confondue avec l'entrée du premier élément de registre R11, et la sortie S du registre est confondue avec la sortie du registre R0. A l'instant t4, le transfert des bits à l'intérieur d'un élément de registre peut alors se résumer comme suit:

- pour chaque groupe Ci autre que le dernier groupe C4, le contenu d'un élément de registre déterminé autre que le dernier élément de registre du groupe est transmis à l'élément de registre suivant dans le groupe;
- le contenu du dernier élément de registre des groupes ci-dessus est transmis au premier élément de registre du groupe suivant $C_{i+1}$;

- le contenu du dernier élément de registre RO du dernier groupe C4 est perdu; à l'inverse, le bit d'information présent sur l'entrée E du registre est alors sauvegardé dans le premier élément de registre R11 du premier groupe C1.

A la figure 6, ces évènements sont matérialisés par des flèches.

Le rôle des multiplexeurs 10, 20, 30 et 40 commandés par le signal de sélection SELECT est de sélectionner un parcours pour les bits d'information se présentant sur l'entrée E du registre en combinaison avec les signaux de déclenchement CK1 et CK2 et avec le signal de sélection SELECT. Le choix d'un multiplexeur à deux entrées est conditionné par la simplicité de cette solution, étant bien entendu que des circuits combinatoires plus complexes mettant en oeuvre un certain nombre de portes logiques est également envisageable. Il existe ainsi des variantes de bascules où un multiplexeur est intégré dans la bascule. L'usage de ces bascules est possible ici mais ne change pas la fonctionnalité du circuit.

Comme on l'aura compris, les multiplexeurs sont commandés par l'unité de gestion CU pour faire fonctionner la mémoire alternativement selon la première et la seconde phase de fonctionnement. Une itération de ces deux phases permet de mémoriser P bits d'information, qu'il faut répéter L fois pour mémoriser N bits se présentant en série à l'entrée E de la mémoire.

Le fonctionnement de la mémoire selon l'invention, telle qu'il vient d'être décrit, est absolument transparent si l'on considère la circulation des données entre l'entrée E et la sortie S de la mémoire. En effet, si l'on fait abstraction de ce qui se passe à l'intérieur de la mémoire entre ces deux points, la mémoire selon l'invention fonctionne à la manière des mémoires à accès séquentiels antérieurement connues. Notamment, l'écriture et la lecture dans la mémoire se déroulent au rythme du signal d'horloge CK (c'est-à-dire à la fréquence f). La mémoire selon l'invention est donc facilement utilisable dans des circuits qui utiliseraient des mémoires selon l'art antérieur, et avec les mêmes performances en vitesse de lecture et d'écriture que celles de l'état de la technique.

Cependant, seuls les P derniers éléments de registre R3, R2, R1 et R0 de chaque groupe C1, C2, C3 et C4 sont activés à chaque front montant du signal d'horloge CK. Les N - P autres éléments de registre ne sont activés qu'une seule fois sur P périodes du signal d'horloge CK, soit L fois sur N périodes du signal d'horloge CK.

On peut montrer que la consommation de la mémoire selon l'invention est de ce fait significativement réduite par rapport à la consommation des mémoires similaires de l'art antérieur. Ainsi, si l'on reprend le calcul de l'énergie dynamique ED' consommée par la mémoire selon l'invention pour l'écriture d'un mot de N bits dans les N éléments de registre, il vient:

$$ED' = e \times P \times N + e \times (N - P) \times L$$

soit, avec P = N/L,

$$ED' = e \times N^2/L + e \times (N - N/L) \times L$$

$$ED = e \times N^2 \times (1/L + L/N - 1/N)$$

$$ED' = ED \times (1/L + L/N - 1/N)$$

On conçoit facilement que, pour de grandes valeurs de N, l'énergie dynamique ED' consommée par la mémoire selon l'invention est réduite d'un facteur de l'ordre de L par rapport à celle ED consommée par une mémoire comparable de l'art antérieur (étant observé que, dans la pratique, les mémoires comportent en général plusieurs milliers d'éléments de registre).

Dans les calculs ci-dessus, on a négligé la contribution des moyens de génération des signaux de fonctionnement CK1, CK2 et SELECT qui est négligeable pour les grandes valeurs de N. CK1 est toujours actif et est équivalent au signal CK de la figure 1.

## Revendications

1. Mémoire à accès séquentiels fonctionnant au rythme d'un signal d'horloge (CK) et comprenant N éléments de registre bistables et synchrones mémorisant chacun un bit d'information, **caractérisée en ce que** les N éléments sont répartis en P groupes (C1-C4) comprenant chacun L éléments, et **en ce que** une unité de gestion (CU) fait fonctionner la mémoire de telle manière que

   dans une première phase de fonctionnement dont la durée correspond à P - 1 périodes consécutives du signal d'horloge, seuls les derniers éléments (R3, R2, R1, R0) de chaque groupe ($C_1$ - $C_4$) sont activés et sont par ailleurs connectés en série, l'entrée du premier (R3) de ces éléments constituant alors l'entrée de la mémoire et la sortie du dernier élément (R0) constituant alors la sortie de la mémoire, alors que, dans une seconde phase de fonctionnement dont la durée correspond à une unique période du signal d'horloge, tous les éléments (R0-R11) sont activés, les groupes d'éléments étant en outre connectés en série, l'entrée du premier élément (R11) du premier groupe (C1) constituant alors l'entrée de la mémoire, et la sortie du dernier élément (R0) du dernier groupe (C4) constituant alors la sortie de la mémoire.

2. Mémoire selon la revendication 1, **caractérisée en ce que** un moyen de sélection est disposé entre la sortie du pénultième élément et l'entrée du dernier élément de chaque groupe, ces moyens de sélection étant commandés par l'unité de gestion (CU) pour faire fonctionner la mémoire alternativement selon ladite première et ladite seconde phase de fonctionnement.

3. Mémoire selon la revendication 2, **caractérisée en ce que** le moyen de sélection comprend:

   - une première entrée connectée à la sortie du pénultième élément du groupe concerné,
   - une seconde entrée qui, pour un premier groupe d'éléments, reçoit les données entrant dans la mémoire qui sont par ailleurs transmises en entrée du premier élément du groupe, et, pour les autres groupes, est connectée à la sortie du dernier élément du groupe précédent, celle-ci étant par ailleurs connectée à l'entrée du premier élément du groupe concerné,
   - une sortie connectée à l'entrée du dernier élément du groupe concerné, l'état de ladite sortie étant égal soit à l'état de ladite première entrée, soit à l'état de ladite seconde entrée en fonction de l'état d'une troisième entrée.

4. Mémoire selon la revendication 1, **caractérisée en ce que** le moyen de sélection est un multiplexeur à deux voies.

**Patentansprüche**

1. Speicher zum sequentiellen Zugriff, wobei der Speicher gemäß eines Taktsignals (CK) arbeitet und N bistabile und synchronisierte Registerelemente umfaßt, die jeweils ein Informationsbit speichert, **dadurch gekennzeichnet, daß** die N Elemente auf P Gruppen (C1 - C4) verteilt sind, welche jeweils L Elemente umfassen, und daß eine Verarbeitungseinheit (CU) den Speicher in einer Weise steuert, so **daß**
in einer ersten Funktionsphase, deren Dauer P -1 aufeinanderfolgende Perioden des Taktsignals entspricht, nur die letzten Elemente (R3, R2, R1, R0) jeder Gruppe (C1 - C4) aktiviert und zudem in Serie verbunden sind, der Eingang des ersten (R3) dieser Elemente daher den Eingang des Speichers bildet und der Ausgang des letzten Elementes (R0) den Ausgang des Speichers bildet,
wobei in einer zweiten Funktionsphase, deren Dauer einer einzelnen Periode des Taktsignals entspricht, alle Elemente (R0 - R11) aktiviert sind, die Gruppen der Elemente zudem in Serie verbunden sind, der Eingang des ersten Elementes (R1) der ersten Gruppe (C1) daher den Eingang des Speichers bildet und der Ausgang des letzten Elementes (R0) der letzten Gruppe (C1) den Ausgang des Speichers bildet.

2. Speicher nach Anspruch 1, **dadurch gekennzeichnet, daß** zwischen dem Ausgang des vorletzten Elementes und dem Eingang des letzten Elementes jeder Gruppe Auswahlmittel angeordnet sind, wobei diese Auswahlmittel von der Verarbeitungseinheit (CU) so gesteuert werden, daß der Speicher alternativ entsprechend der ersten und der zweiten Funktionsphase arbeitet.

3. Speichereinheit nach Anspruch 2, **dadurch gekennzeichnet, daß** die Auswahlmittel umfassen:

   einen ersten Eingang, der mit dem Ausgang des vorletzten Elementes der betreffenden Gruppe verbunden ist,
   einen zweiten Eingang, der für eine erste Gruppe von Elementen die in den Speicher eintretenden Daten empfängt, welche sonst an den Eingang des ersten Elementes der Gruppe übertragen werden, und der für die anderen Gruppen mit dem Ausgang des letzten Elementes der vorhergehenden Gruppe verbunden ist, der andernfalls mit dem Eingang des ersten Elementes der betreffenden Gruppe verbunden ist,
   einen mit dem Eingang des letzten Elementes der betreffenden Gruppe verbundener Ausgang, wobei der Zustand dieses Ausgangs, abhängig von dem Zustand eines dritten Eingangs, entweder dem Zustand des ersten Eingangs oder dem Zustand des zweiten Eingangs entspricht.

4. Speichereinheit gemäß Anspruch 1, **dadurch gekennzeichnet, daß** die Auswahlmittel ein Zweiwege-Multiplexer sind.

**Claims**

1. Sequential access memory operating at the rate of a clock signal (CK) and comprising N bistable and synchronous register elements each storing an information bit, **characterised in that** the N elements are divided into P groups (C1-C4) each comprising L elements, and **in that** a control unit (CU) causes the memory to operate in such a way that:

   in a first operating phase, the duration of which corresponds to P - 1 consecutive periods of the clock signal, only the last elements (R3, R2, R1, R0) of each group (C1-C4) are activated and are furthermore connected in series, the input of the first (R3) of these elements then constituting the input of the memory and the output of the last element (R0) then constituting the output of the memory,

whilst, in a second operating phase, the duration of which corresponds to a single period of the clock signal, all the elements (R0-R11) are activated, the groups of elements also being connected in series, the input of the first element (R11) of the first group (C1) then constituting the input of the memory, and the output of the last element (R0) of the last group (C4) then constituting the output of the memory.

2. Memory according to Claim 1, **characterised in that** a selection means is arranged between the output of the penultimate element and the input of the last element of each group, these selection means being controlled by the control unit (CU) so as to cause the memory to operate alternately in said first and said second operating phase.

3. Memory according to Claim 2, **characterised in that** the selection means comprises:

a first input connected to the output of the penultimate element of the group concerned,

a second input which, for a first group of elements, receives the data entering the memory that are furthermore transmitted to the input of the first element of the group and, for the other groups, is connected to the output of the last element of the preceding group, said output being furthermore connected to the input of the first element of the group concerned,

an output connected to the input of the last element of the group concerned, the state of said output being equal either to the state of said first input or to the state of said second input as a function of the state of a third input.

4. Memory according to Claim 1, **characterised in that** the selection means is a two-channel multiplexer.

EP 0 889 481 B1

## FIG_1

## FIG_2

FIG_3

EP 0 889 481 B1

| $R_{11}$ | $R_{10}$ | $R_9$ | $R_8$ |
|---|---|---|---|
| $R_7$ | $R_6$ | $R_5$ | $R_4$ |
| $R_3$ | $R_2$ | $R_1$ | $R_0$ |

FIG_4

FIG_5

FIG_6

FIG_7a

FIG_7b

FIG_7c

FIG_7d

FIG_8

| | t0 | t1 | t2 | t3 | t4 | t5 | t6 | t7 | t8 | t9 | t10 | t11 | t12 |
|---|---|---|---|---|---|---|---|---|---|---|---|---|---|
| R0 | s0 | s1 | s2 | s3 | s4 | s5 | s6 | s7 | s8 | s9 | s10 | s11 | e0 |
| R1 | s1 | s2 | s3 | e0 | s5 | s6 | s7 | e4 | s9 | s10 | s11 | e8 | e1 |
| R2 | s2 | s3 | e0 | e1 | s6 | s7 | e4 | e5 | s10 | s11 | e8 | e9 | e2 |
| R3 | s3 | e0 | e1 | e2 | s7 | e4 | e5 | e6 | s11 | e8 | e9 | e10 | e3 |
| R4 | s4 | s4 | s4 | s4 | s8 | s8 | s8 | s8 | e0 | e0 | e0 | e0 | e4 |
| R5 | s5 | s5 | s5 | s5 | s9 | s9 | s9 | s9 | e1 | e1 | e1 | e1 | e5 |
| R6 | s6 | s6 | s6 | s6 | s10 | s10 | s10 | s10 | e2 | e2 | e2 | e2 | e6 |
| R7 | s7 | s7 | s7 | s7 | s11 | s11 | s11 | s11 | e3 | e3 | e3 | e3 | e7 |
| R8 | s8 | s8 | s8 | s8 | e0 | e0 | e0 | e0 | e4 | e4 | e4 | e4 | e8 |
| R9 | s9 | s9 | s9 | s9 | e1 | e1 | e1 | e1 | e5 | e5 | e5 | e5 | e9 |
| R10 | s10 | s10 | s10 | s10 | e2 | e2 | e2 | e2 | e6 | e6 | e6 | e6 | e10 |
| R11 | s11 | s11 | s11 | s11 | e3 | e3 | e3 | e3 | e7 | e7 | e7 | e7 | e11 |
| S | s0 | s1 | s2 | s3 | s4 | s5 | s6 | s7 | s8 | s9 | s10 | s11 | e0 |
| E | e0 | e1 | e2 | e3 | e4 | e5 | e6 | e7 | e8 | e9 | e10 | e11 | e12 |

EP 0 889 481 B1